# DEMANDE DE BREVET EUROPEEN

(11) **EP 1 580 759 A1**
(43) Date de publication de la demande: **28.09.2005**
(21) Numéro de dépôt: 05290315.0
(22) Date de dépôt: 11.02.2005
(51) Int. Cl.: G11C 11/16, G11C 5/14, H03F 3/45

(54) **Dispositif pour l'établissement d'un courant d'écriture dans une mémoire de type MRAM et mémoire comprenant un tel dispositif**

(30) Priorité: 18.03.2004 FR 0402818
(71) Demandeur: STMicroelectronics S.A., 92120 Montrouge (FR)
(72) Inventeur: Lasseuguette, Jean, 38000 Grenoble (FR); Dray, Cyrille, 38320 Eybens (FR); Barasinski, Sébastien, 38240 Meylan (FR)
(74) Mandataire: Bentz, Jean-Paul

(57) **Abrégé**

L'invention concerne un dispositif pour l'établissement d'un courant d'écriture (Iwrite) au niveau d'au moins une ligne conductrice d'écriture (WLO) d'une mémoire en circuit intégré de type MRAM, caractérisé en ce qu'il comprend un miroir de courant constitué d'un premier étage cascode régulé de référence (Cin) recevant sur son entrée tout ou partie du courant d'écriture et d'un second étage cascode régulé de recopie (Cout) recopiant le courant d'écriture sur la ligne d'écriture.

## Description

La présente invention concerne, en général, le domaine des mémoires vives magnétiques de type MRAM et se rapporte plus particulièrement à un dispositif pour l'établissement d'un courant d'écriture au niveau d'au moins une ligne conductrice d'écriture dans une mémoire en circuit intégré de type MRAM.

Les mémoires vives magnétiques MRAM (acronyme anglo-saxon pour « Magnetic Random Access Memory ») sont des mémoires de type non volatile. Typiquement, un dispositif de mémoire vive magnétique comprend une matrice de cellules mémoire disposées en rangées et en colonnes, à travers laquelle sont acheminées des pistes métalliques. Les pistes métalliques s'étendant le long des rangées de cellules mémoire sont appelées lignes de mot et les pistes métalliques s'étendant le long des colonnes de cellules mémoire sont appelées lignes de bit. Chaque cellule mémoire ainsi placée à l'intersection d'une ligne de mot et d'une ligne de bit mémorise un élément d'information sous forme d'orientation de magnétisation.

Chacune des cellules mémoire est en effet constituée de deux couches magnétiques, séparées par une couche diélectrique. Chaque couche magnétique possède une orientation propre de magnétisation. L'orientation de la magnétisation d'une des couches, dite couche libre, est modifiable, tandis que l'orientation de la magnétisation de l'autre couche, dite couche fixée, est fixe dans une orientation particulière. Les orientations de la magnétisation des deux couches peuvent se trouver dans deux situations : soit parallèles, c'est-à-dire alignées dans la même direction, soit anti-parallèles, c'est-à-dire alignées dans des directions opposées. Ces deux orientations, parallèle et anti-parallèle, représentent les valeurs logiques « 1 » et « 0 », respectivement. En variante, l'état parallèle peut être interprété comme un « 0 » logique et l'état anti-parallèle comme un « 1 » logique.

Dès lors, l'écriture pour une telle cellule mémoire consiste à positionner l'orientation de magnétisation dans la couche libre en fonction de l'état logique souhaité, dans un état soit parallèle, soit anti-parallèle, par rapport à l'orientation de magnétisation de la couche fixée.

Typiquement, des champs magnétiques externes sont appliqués sur une cellule sélectionnée pour basculer l'orientation de magnétisation dans la couche libre de cette cellule d'un état à un autre. Pour ce faire, un courant d'écriture est appliqué respectivement sur la ligne de mot et la ligne de bit se coupant à l'emplacement de la cellule mémoire sélectionnée. Les courants d'écriture ainsi appliqués sur la ligne de mot et la ligne de bit sélectionnées créent des champs magnétiques qui, lorsqu'ils se combinent à l'intersection de la ligne de mot et de la ligne de bit, permettent de commuter l'orientation de magnétisation de la couche libre de la cellule mémoire sélectionnée de l'état parallèle à anti-parallèle, ou vice-versa, en fonction de la donnée qui doit être écrite dans la cellule.

Le basculement d'un état à un autre d'une cellule mémoire sélectionnée en écriture nécessite des champs magnétiques élevés, ce qui impose de faire circuler des courants d'écriture suffisamment forts, de l'ordre de la dizaine de milliampères, au niveau des pistes métalliques constituant les lignes de mot et de bit à l'intersection desquelles se trouve la cellule mémoire sélectionnée en écriture. Il est à cet effet nécessaire de pouvoir maîtriser la valeur de l'intensité du courant d'écriture circulant sur les pistes métalliques avec une grande précision, de même que la vitesse d'établissement des fronts de montée et de descente de l'intensité du courant d'écriture.

Certaines contraintes doivent en effet être prises en compte au cours des phases d'établissement et d'arrêt de l'impulsion de courant nécessaire au basculement de l'aimantation d'une cellule mémoire MRAM pour sa programmation. Ainsi, lors de la phase d'établissement, si la pente de l'impulsion de courant est trop forte, c'est-à-dire que le niveau de courant nécessaire pour programmer une cellule s'établit de manière trop brusque, des phénomènes oscillatoires risquent de se produire induisant en conséquence une forte instabilité de l'orientation de magnétisation de la cellule mémoire sélectionnée en écriture. La vitesse d'établissement du courant d'écriture doit donc être relativement faible pour éviter ce problème. Toutefois, la durée de cycle d'écriture sera d'autant plus longue que la vitesse d'établissement du courant sera faible. Aussi, il y un compromis à trouver au niveau de la pente de l'impulsion de courant d'écriture, de manière à éviter les phénomènes oscillatoires tout en ne pénalisant pas la durée de cycle d'écriture, qui est un paramètre important pour les mémoires en général.

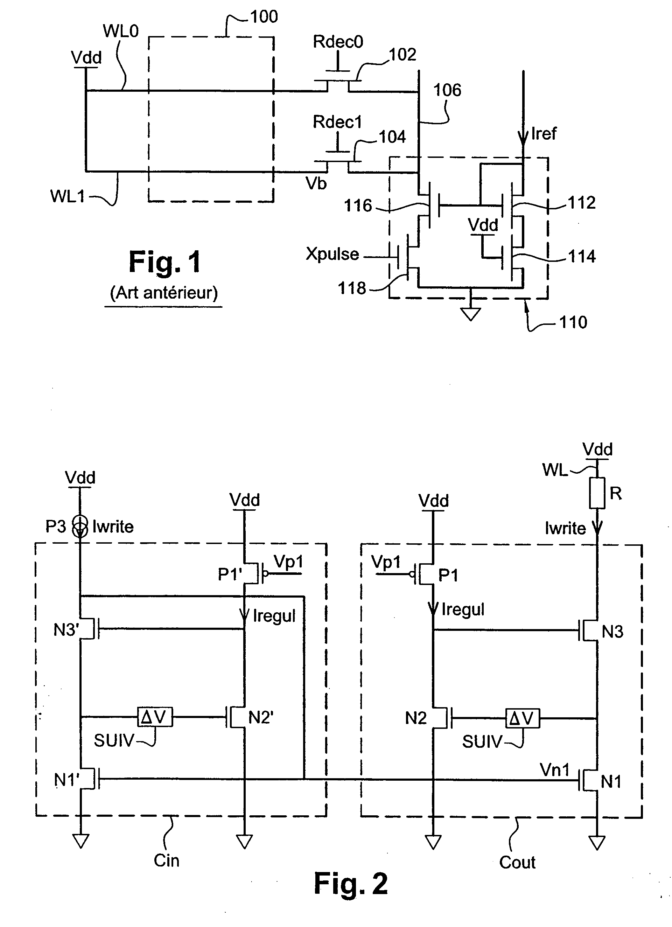

Le brevet US 6,657,889 (D1), au nom de la société Motorola, décrit un dispositif mémoire de type MRAM dont la circuiterie d'écriture est basée sur une succession de plusieurs étages de miroir de courant et qui comporte des moyens de contrôle de la pente d'établissement du courant d'écriture. La figure 1 de la présente demande illustre de façon simplifiée une partie de la circuiterie d'écriture du dispositif de mémoire MRAM selon D1.

Une matrice de cellules mémoire de type MRAM est représentée par le cadre en pointillés référencé 100 sur la figure 1. La matrice 100 comprend une pluralité de lignes de bit d'écriture et une pluralité de lignes de mot d'écriture, typiquement 128 ou 256 lignes, à l'intersection desquelles sont positionnées les cellules mémoires, non représentées sur la figure. Dans un souci de simplifier l'explication, seules deux lignes de mots d'écriture WL0 et WL1 sont représentées. La circuiterie d'écriture associée qui va être décrite ci-après se retrouve bien entendu de la même façon au niveau des lignes de bit de la matrice de cellules mémoire.

Une alimentation Vdd est connectée à une extrémité de chacune des lignes de mot WL0 et WL1. L'autre extrémité de chaque ligne d'écriture WL0 et WL1 est connectée au drain d'un transistor NMOS, respectivement 102 et 104, dédié à l'adressage des cellules mémoire de la matrice. La grille du transistor 102 est connectée à un signal de contrôle Rdec0 fourni par un décodeur d'adresse et sa source est connectée à un miroir de courant 110 via un conducteur 106. La grille du transistor 104 est connectée à un signal de contrôle Rdec1 fourni par le décodeur d'adresse et sa source est connectée au miroir de courant 110 via le conducteur 106. Des transistors NMOS 112, 114, 116 et 118 forment le miroir de courant 110, lequel est attaqué par un courant de référence Iref d'une intensité de plusieurs milliampères. La branche composée des transistors 116 et 118 de l'étage miroir de courant 110 est rendue passante pendant un cycle d'écriture à l'activation d'un signal de synchronisation Xpulse sur la grille du transistor 118. Le transistor 116 assure ainsi un contrôle analogique du courant fourni par le miroir de courant 110, tandis que le transistor 118 permet de gérer la durée de l'impulsion du courant d'écriture. Ainsi, lorsque le cycle d'écriture concerne une cellule mémoire de la ligne de mot WL1, le transistor 104 est rendu passant par l'activation du signal de contrôle Rdec1 et le courant de recopie Iref est établi au niveau de la ligne de mot WL1 une fois que le signal Xpulse est activé. Le contrôle de la pente d'impulsion du courant d'écriture est quant à lui assuré par les capacités de jonction des transistors, préchargées à un potentiel déterminé. Un processus équivalent est mis en oeuvre au niveau de la ligne de bit correspondant à la cellule adressée.

L'architecture proposée par D1 assure une relativement bonne précision du courant d'écriture obtenu par recopie dans le miroir de courant, avec toutefois une contrainte pour parvenir à ce résultat. Le transistor 116 doit ainsi nécessairement fonctionner en zone saturée. En effet, dans ce mode de fonctionnement, le courant de saturation d'un transistor est faiblement dépendant de la tension sur son drain. Pour un fonctionnement des transistors en zone saturée, la condition suivante doit être respectée : Vds ≥ Vgs-Vt (1), avec Vds la tension drain-source du transistor, Vgs la tension grille-source et Vt la tension de seuil du transistor.

Or, les pistes conductrices constituant les lignes de mot sont par nature résistives. Le fait de faire circuler un fort courant de l'ordre de la dizaine de milliampères sur la ligne de mot WL1 va donc inévitablement provoquer une chute du potentiel Vb à l'extrémité de celle-ci, par application de la loi d'Ohm, et en conséquence, une chute de la tension de drain du transistor MOS 104, ainsi que du transistor 116 du miroir de courant. La tension drain-source des transistors va donc chuter, ce qui risque d'entraîner les transistors à fonctionner en zone linéaire. Dans ce cas, il n'est plus possible de garantir la recopie du courant au niveau de la ligne WL1 avec une bonne précision.

Pour maintenir un fonctionnement en condition de saturation malgré la chute de potentiel à l'extrémité de la ligne WL1, D1 prévoit des transistors MOS fonctionnant avec une tension grille-source Vgs faible, de sorte à respecter la condition (1) sur une plage de fonctionnement la plus étendue possible. Or, un transistor MOS qui fonctionne avec une tension grille-source faible et qui est néanmoins prévu pour faire passer un fort courant, doit avoir un dimensionnement important, typiquement de l'ordre de 1mm de largeur. Ainsi, la précision de la recopie de courant, qui est directement liée selon cette solution de l'art antérieur à un régime de fonctionnement des transistors en mode saturée, est obtenue au détriment de la taille des transistors constituant le miroir de courant, ce qui est pénalisant en terme de densité d'intégration de la mémoire.

Toutefois, si la chute de potentiel en bout de ligne est telle que Vb<1V, il devient alors très difficile de maintenir un fonctionnement en régime de saturation des transistors sur le passage du courant, même avec un gros dimensionnement. Une tension en bout de ligne importante doit donc pouvoir être maintenue, au minimum Vb>1V, pour espérer assurer un fonctionnement de l'ensemble avec une précision correcte.

La présente invention a pour but de remédier aux inconvénients de l'art antérieur en proposant un dispositif pour l'établissement d'un courant d'écriture au niveau des lignes d'écriture d'un plan mémoire de type MRAM, qui garantisse une très bonne précision dans la recopie du courant d'écriture fourni avec une tension nécessaire au bon fonctionnement réduite en bout de ligne.

Avec cet objectif en vue, l'invention a pour objet un dispositif pour l'établissement d'un courant d'écriture au niveau d'au moins une ligne conductrice d'écriture d'une mémoire en circuit intégré de type MRAM, caractérisé en ce qu'il comprend un miroir de courant constitué d'un premier étage cascode régulé de référence recevant sur son entrée tout ou partie du courant d'écriture et d'un second étage cascode régulé de recopie recopiant le courant d'écriture sur la ligne d'écriture.

De préférence, le dispositif selon l'invention est utilisé pour établir un courant d'écriture au niveau d'une pluralité de lignes d'écriture, chaque ligne étant connectée au drain d'un transistor MOS respectif de l'étage cascode régulé de recopie, ledit transistor MOS assurant l'adressage de la ligne d'écriture à laquelle il est associé parmi ladite pluralité de lignes.

Dans cette configuration selon l'invention, chaque transistor MOS d'adressage est connecté par sa source au drain d'un transistor MOS commun de l'étage cascode régulé de recopie, prévu pour fixer la valeur du courant d'écriture et dont la grille est connectée en sortie de l'étage cascode régulé de référence.

Selon un mode de réalisation préféré de l'invention, l'étage cascode régulé de recopie comprend une branche d'asservissement composée d'un transistor MOS dont la tension de grille est fonction d'un courant fourni par une source de courant à laquelle il est connecté par son drain, le drain du transistor MOS commun fixant le courant d'écriture est connecté à la grille dudit transistor MOS de la branche d'asservissement par l'intermédiaire d'un étage suiveur de tension fournissant un incrément de tension déterminé à la tension de grille fixée dudit transistor MOS de ladite branche d'asservissement.

Avantageusement, pour chaque ligne d'écriture considérée, la grille du transistor MOS d'adressage associé est connectée à une porte de transfert présentant deux états en fonction d'un signal d'adressage qui lui est appliqué, un premier état où ladite grille est tirée à la masse et un second état où ladite grille est connectée au drain du transistor MOS de la branche d'asservissement de l'étage cascode régulé de recopie, permettant le passage du courant d'écriture fixé par le transistor commun à travers ledit transistor MOS d'adressage sur ladite ligne.

Selon un mode de réalisation particulier, l'étage cascode régulé de recopie comprend des moyens de contrôle de la pente d'établissement du courant d'écriture.

Selon ce mode de réalisation particulier, les moyens de contrôle de la pente d'établissement du courant d'écriture comprennent au moins un condensateur, connecté au drain du transistor MOS de la branche d'asservissement de l'étage cascode régulé de recopie, par l'intermédiaire d'une porte de transfert respective, ladite porte étant prévue pour être activée lorsque aucune ligne n'est adressée en écriture, de sorte à faire évoluer la capacité équivalente au niveau du drain du transistor MOS de ladite branche d'asservissement.

Selon un mode de réalisation, la source de courant de la branche d'asservissement de l'étage cascode régulé de recopie comprend un transistor PMOS dont la grille est connectée à une tension de polarisation, la source est connectée à une tension d'alimentation et le drain est connecté au drain de l'autre transistor MOS de la branche d'asservissement, lesdits transistors de la branche d'asservissement fonctionnant en régime de saturation.

Selon un mode de réalisation, l'étage suiveur de tension comprend un premier transistor PMOS, dont la source est connectée à une tension d'alimentation, la grille est connectée à une tension de polarisation et le drain est connecté à la source d'un second transistor PMOS dont le drain est connecté à la masse, ladite source dudit second transistor PMOS étant connectée à la grille du transistor MOS de la branche d'asservissement et la grille dudit second transistor PMOS dudit étage suiveur de tension étant connectée au drain du transistor MOS commun prévu pour fixer la valeur du courant d'écriture, ledit second transistor PMOS dudit étage suiveur de tension étant prévu pour appliquer une tension reçue sur sa grille au niveau de sa source en y ajoutant l'incrément de tension.

L'invention concerne encore une mémoire de type MRAM, caractérisée en ce qu'elle comprend au moins un dispositif d'établissement d'un courant d'écriture tel que précédemment défini.

Une mémoire selon l'invention organisée matriciellement en lignes de bit d'écriture et en lignes de mot d'écriture, comprend un dispositif d'établissement d'un courant d'écriture pour l'ensemble des lignes de bit d'écriture et pour l'ensemble des lignes de mot d'écriture respectivement.

L'invention concerne enfin un circuit intégré comprenant un dispositif d'établissement d'un courant d'écriture ou une mémoire tels qu'ils viennent d'être définis selon l'invention.

D'autres caractéristiques et avantages de la présente invention apparaîtront plus clairement à la lecture de la description suivante, donnée à titre d'exemple illustratif et non limitatif et faite en référence aux figures annexées dans lesquelles :
- la figure 1 est un schéma illustrant une solution de l'art antérieur pour l'établissement d'un courant d'écriture au niveau d'une ligne d'écriture d'une matrice de cellules mémoires MRAM et a déjà été décrite ;
- la figure 2 est un schéma illustrant le dispositif d'établissement d'un courant d'écriture selon l'invention, représenté pour une seule ligne d'écriture sans les fonctions d'adressage ;
- la figure 3 est un schéma de l'étage cascode régulé de recopie de la figure 2 où est illustré un mode de réalisation préféré pour la réalisation de l'étage suiveur de tension,
- la figure 4 est un schéma illustrant une mise en commun pour n lignes d'écriture du dispositif selon l'invention, avec les fonctions d'adressage de ces lignes représentées, et
- la figure 5 illustre une représentation simplifiée de la figure 4 avec une seule ligne d'écriture, où sont décrits en plus des moyens de contrôle de la pente d'établissement du courant d'écriture.

Ainsi, en référence à la figure 2, une ligne d'écriture WL d'une mémoire de type MRAM est représentée schématiquement par sa charge résistive équivalente R, connectée par une première extrémité à une tension d'alimentation Vdd. Cette charge peut représenter une rangée ou une colonne de la matrice de la mémoire MRAM.

Le dispositif pour l'établissement d'un courant d'écriture sur la ligne d'écriture WL comprend deux étages de type cascode régulé configurés en miroir de courant pour établir un courant d'écriture Iwrite au niveau de la ligne d'écriture WL. Ainsi, le dispositif selon l'invention comprend un miroir de courant constitué d'un premier étage cascode régulé Cin, dit de référence, recevant sur son entrée le courant d'écriture Iwrite à appliquer sur la ligne d'écriture WL, et d'un second étage cascode régulé Cout en miroir assurant la recopie du courant Iwrite sur la ligne d'écriture.

L'étage Cout comprend une première branche d'asservissement comprenant une source de courant débitant un courant Iregul. La source de courant Iregul comprend un transistor PMOS P1 dont la grille est connectée à une tension de polarisation Vp1, générée par un circuit non représenté sur la figure, et dont la source est connectée à la tension d'alimentation Vdd. Le drain du transistor P1 est connecté au drain d'un transistor NMOS N2 dont la source est connectée à la masse. Les transistors P1 et N2 sont prévus pour fonctionner en mode saturé. De cette façon, le transistor N2 est soumis à une polarisation par courant constant sur son drain, ce qui permet d'asservir sa tension de grille par la circulation du courant Iregul. En effet, quand le MOS N2 est en zone saturée, pour une tension grille-source Vgs donnée, le transistor fait toujours circuler le même courant quelle que soit la tension sur son drain. On va donc forcer le courant Iregul dans N2, de sorte que la tension Vgs de N2 s'établisse lui permettant de fonctionner en zone saturée. Ainsi, tant que N2 est en zone saturée, sa tension Vgs est fixée par le courant Iregul fourni par P1. La tension Vgs de N2 dépend également de son dimensionnement W/L.

L'étage Cout comprend une deuxième branche, comprenant un transistor NMOS N1 dont la tension de grille Vn1 est générée en sortie de l'étage cascode régulé Cin, et dont le drain est connecté directement, selon un premier mode de réalisation, à la grille du transistor N2 de la première branche. La tension de drain de N1 est donc asservie par la tension de grille du transistor N2 de la première branche. Le transistor N1 a plus particulièrement pour rôle de fixer le courant d'écriture qui est prévu pour circuler dans la charge R. Le transistor N1 est également connecté par son drain à la source d'un transistor NMOS N3, dont le drain est connecté à la seconde extrémité de la ligne d'écriture WL et dont la grille est connectée directement, selon le premier mode de réalisation, au drain des transistors P1 et N2. L'ensemble des connexions respectives entre le drain de N1 et la grille de N2, le drain de N2 et la grille de N3 et la source de N3 et le drain de N1, forme la boucle de contre-réaction de l'étage cascode régulé Cout, les transistors N2 et N3 faisant partie de la boucle.

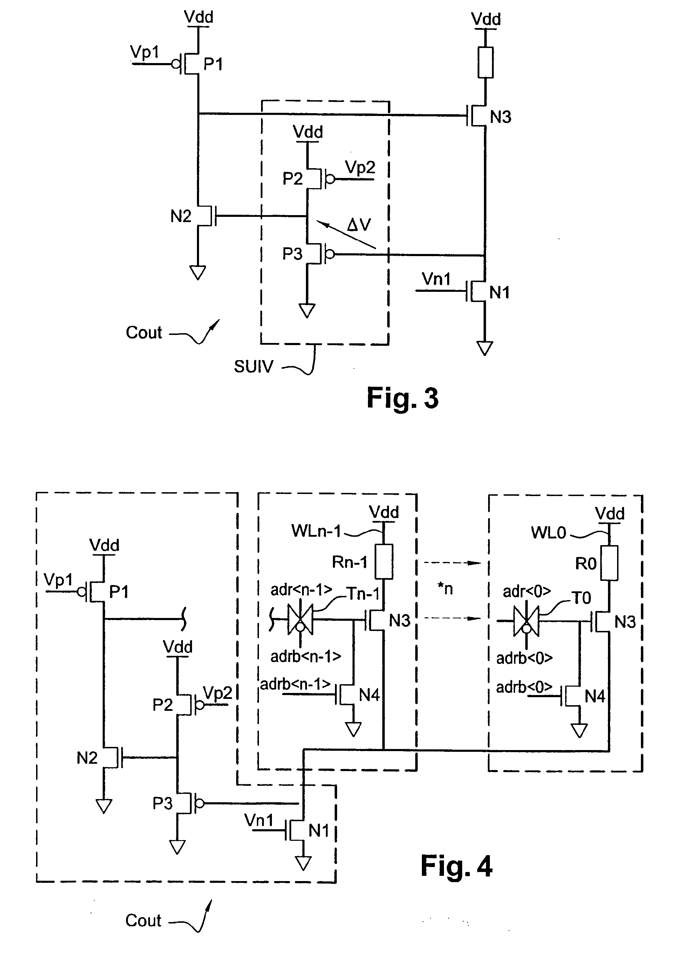

Le transistor N3 est quant à lui plus particulièrement dédié à l'adressage de la ligne d'écriture WL, en combinaison avec un autre élément d'adressage non représenté sur cette figure et qui sera décrit en référence avec la figure 4. Le transistor N3 a également une fonction de régulation de tension en absorbant la chute de tension aux bornes de la charge R due au passage du courant d'écriture et en permettant ainsi de maintenir une tension constante sur sa source.

En effet, la tension sur le drain du transistor N1 étant fixée par le transistor N2, la valeur du courant circulant dans le transistor N3 est fixée par le transistor N1. Comme le transistor N2 a de plus une tension de grille constante et fonctionne en zone saturée, la tension sur son drain n'a que très peu d'impact sur la polarisation de la branche d'asservissement et cette tension correspondant à la tension de grille de N3 va s'établir de sorte à ce que la tension grille-source Vgs du transistor N3 s'établisse pour faire circuler le courant fixé par N1.

De façon avantageuse, grâce à la configuration particulière de l'étage cascode régulé, on obtient une décorrélation de la fonction d'adressage de la ligne d'écriture et de la fonction de contrôle dynamique du courant d'écriture lors d'un processus d'établissement du courant d'écriture Iwrite sur la ligne d'écriture WL.

L'étage Cout assurant la recopie du courant Iwrite sur la ligne d'écriture WL est le miroir de l'étage cascode régulé Cin. La structure de la branche d'asservissement se retrouve donc exactement au niveau de l'étage de référence Cin, avec des transistors P1' et N2' configurés de la même façon que les transistors P1 et N2 de l'étage Cout. Les transistors P1', N2' et P1, N2 de chaque étage sont taillés de façon identique et le même courant Iregul circule dans la branche d'asservissement de chacun des étages.

L'étage Cin comprend également une deuxième branche recevant sur son entrée le courant d'écriture Iwrite devant être recopié sur la ligne d'écriture WL. Le courant Iwrite est fourni par une source de courant P3 connectée au drain d'un transistor NMOS N3' de la deuxième branche de l'étage Cin. La source de N3' est connectée au drain d'un transistor NMOS N1' dont la source est connectée à la masse. Le transistor N3' est également connecté par son drain à la grille du transistor N1'. Le drain du transistor N1' est connecté à la grille du transistor N2 de la branche d'asservissement et la grille du transistor N3' est connectée au drain des transistors P1' et N2' de la branche d'asservissement, l'ensemble de ces connexions formant la boucle de contre-réaction de l'étage cascode régulé Cin. Enfin, la grille du transistor N1' est connectée directement à la grille du transistor N1 de l'étage Cout. La tension Vn1 polarisant la grille du transistor N1 de l'étage cascode régulé Cout est ainsi générée par la tension de grille du transistor N1'.

Dans l'exemple de la figure 2, la source de courant P3 génère le courant Iwrite qui est prévu pour circuler au niveau de la ligne d'écriture WL. Dans ce cas, les transistors N1 et N3, respectivement N1' et N3' sont taillés de la même façon. De préférence, pour des raisons de coût, étant donné que le courant d'écriture Iwrite impliqué est assez élevé, de l'ordre de la dizaine de milliampères, il est prévu de faire circuler à travers les NMOS N3' et N1' une partie seulement du courant d'écriture Iwrite effectivement souhaité dans la ligne d'écriture WL, par exemple un courant égal à 1/16^{ième} du courant d'écriture Iwrite. La source de courant P3 débite alors un courant d'une valeur correspondant à Iwrite/16, qui va circuler dans les transistors N3' et N1' dont la taille est divisée par 16 par rapport à la taille des transistors correspondant N3 et N1 de l'étage Cout. De cette façon, par le processus de recopie à travers le miroir, on a bien un courant Iwrite qui circule au niveau de la ligne d'écriture WL.

Selon un autre mode de réalisation préféré de l'invention, un étage suiveur de tension SUIV est intégré dans la boucle de contre-réaction de chacun des étages cascodes régulés Cin, Cout du miroir de courant et, plus particulièrement entre le drain du transistor N1/N1' et la grille transistor N2/N2'. Ainsi, dans ce mode de réalisation préféré, en référence à l'étage miroir Cout assurant la recopie du courant d'écriture Iwrite au niveau de la ligne d'écriture, le drain du transistor N1 fixant le courant d'écriture est connecté à la grille du transistor MOS N2 de la branche d'asservissement par l'intermédiaire d'un étage suiveur de tension SUIV, prévu pour fournir un incrément de tension ΔV déterminé à la tension de grille du transistor N2.

En effet, pour le bon fonctionnement de l'ensemble, il est essentiel que le transistor N2 travaille en zone saturée, de manière à ce que sa tension de grille reste fixée par le courant Iregul indépendamment de la tension sur son drain, laquelle est en effet amenée à évoluer en fonction de l'ajustement qui s'opère sur la tension de grille de N3, comme expliqué plus haut. Pour ce faire, l'une des conditions à respecter pour le transistor N2, est que sa tension grille-source Vgs soit supérieure à sa tension de seuil Vt. Ainsi, le suiveur de tension SUIV permet avantageusement de fonctionner avec une tension de drain faible pour faire travailler le transistor N1, tout en s'assurant que la tension de grille sur N2 soit au-delà de la tension de seuil Vt de N2. En effet, grâce au suiveur de tension SUIV dans la boucle de contre- réaction, la grille de N2 est polarisée à la tension de drain de N1, volontairement prévue pour être faible, augmentée de l'incrément de tension ΔV, l'incrément de tension ΔV étant prévu pour être supérieur au Vt de N2 de sorte à assurer le fonctionnement attendu pour ce dernier au dessus de son seuil et en régime de saturation.

De plus, grâce à l'étage suiveur de tension SUIV qui permet de faire travailler le transistor N1 avec une tension de drain plus faible, la tension disponible au niveau de la charge résistive équivalente R de la ligne d'écriture est d'autant plus importante. Or, en assurant ainsi un certain niveau de tension disponible aux bornes de la charge R, un bon fonctionnement de la recopie de courant est garanti même quand la charge devient très importante.

Typiquement, le système selon l'invention peut fonctionner correctement en assurant une bonne précision de la recopie du courant d'écriture circulant dans la ligne d'écriture avec une tension en bout de ligne d'écriture relativement faible, de l'ordre de 600 millivolts, la faible tension de drain sur N1 qui en découle étant alors compensée au niveau de la grille de N2 par l'étage suiveur de tension SUIV, qui permet d'assurer un fonctionnement pour N2 au delà de sa tension de seuil, qui est de l'ordre de 700 millivolts. La qualité de la recopie de courant est plus particulièrement due au fait que les transistors P1 et N2, respectivement P1' et N2', qui forment la branche d'asservissement, ainsi que l'étage suiveur de tension SUIV, sont des éléments identiques, configurés de la même façon dans chacun des étages cascodes régulés Cin et Cout, ce qui permet d'imposer des polarisations constantes et identiques au niveau des transistors N1' et N1, qui fixent le courant d'écriture.

La figure 3 est un schéma de l'étage cascode régulé de recopie Cout de la figure 2, où est illustré un mode de réalisation préféré de l'invention pour la mise en oeuvre de l'étage suiveur de tension SUIV au niveau de la boucle de contre-réaction. Selon ce mode de réalisation, l'étage suiveur de tension SUIV comprend un premier transistor PMOS P2, dont la source est connectée à la tension d'alimentation Vdd, dont la grille est connectée à une tension de polarisation Vp2 générée par un circuit non représenté sur la figure, et dont le drain est connecté à la source d'un second transistor PMOS P3, dont le drain est connecté à la masse. La source du second transistor PMOS P3 de l'étage suiveur est connectée à la grille du transistor N2 de la branche d'asservissement et sa grille est connectée au drain du transistor N1 prévu pour fixer la valeur du courant d'écriture. Le transistor P3 de l'étage suiveur de tension SUIV est ainsi prévu pour appliquer au niveau de sa source la tension reçue sur sa grille en y ajoutant l'incrément de tension ΔV. De cette façon, la grille de N2 reçoit la tension de drain de N1 augmenté de ΔV. Dans cette configuration, ΔV correspond à la tension de seuil Vt de P3, plus une composante dépendant du courant fourni par P2.

Un autre avantage apporté par la présence de l'étage suiveur de tension SUIV dans la boucle de contre-réaction concerne la diminution de la taille du transistor N2.

En effet, du fait que N2 est prévu pour travailler avec une tension de grille proche de sa tension de seuil et qu'il doit être en mesure de faire passer le courant débité par P1, il est nécessaire de prévoir un dimensionnement très important, donné par son rapport W/L, pour le transistor N2. En analyse petits signaux, on peut considérer N2 comme un amplificateur classe A avec son signal d'entrée sur sa grille, son signal de sortie sur son drain et une polarisation par courant constant sur son drain. Dans cette configuration, son gain en tension est donné en partie par sa transductance gm. Or, la valeur gm dépend directement et linéairement du dimensionnement du transistor, ce qui fait que plus le transistor est gros, plus le gain est important. L'inconvénient de la taille importante de N2 se traduit ainsi par un gain trop grand dans la boucle de contre-réaction, entraînant une instabilité du système en régime transitoire pour l'établissement du courant d'écriture à la valeur souhaitée une fois qu'une ligne d'écriture a été sélectionnée. Cette instabilité provoque notamment des phénomènes dits d' «overshoot » dans la littérature anglo-saxonne (pic de courant au-delà de la valeur de consigne).

La présence de l'étage suiveur de tension dans la boucle de contre-réaction permet avantageusement de réduire significativement la taille du transistor N2 et donc, de supprimer les inconvénients précités en permettant en régime transitoire un établissement plus direct et mieux maîtrisé du courant à la valeur d'écriture souhaitée. En effet, Le transistor P3 de l'étage suiveur est en configuration source suiveuse avec son signal d'entrée sur sa grille et son signal de sortie sur sa source. Dans cette configuration, l'analyse petits signaux du transistor montre que son gain en tension est légèrement inférieur à 1 (environ 0,8). Il en est de même pour le transistor N3 de la boucle qui est également en configuration source suiveuse. Ainsi, le gain total de la boucle de contre-réaction consistant en une multiplication des gains des différents éléments de la boucle, est donné par N2, P3 et N3, ce dernier n'intervenant toutefois que très peu.

Le dispositif pour l'établissement d'un courant d'écriture dans une MRAM tel qu'il vient d'être décrit aux figures 2 et 3 est une représentation simplifiée du dispositif selon l'invention, puisque sa description a été faite en référence à une ligne d'écriture unique et donc sans la fonction d'adressage. Or, une mémoire MRAM est classiquement organisée matriciellement en une pluralité de lignes de bit d'écriture et en une pluralité de lignes de mot d'écriture, à l'intersection desquelles sont disposées les cellules mémoires MRAM. Le dispositif selon l'invention est donc utilisé pour établir un courant d'écriture au niveau d'une pluralité de lignes de bit ou de mot d'écriture d'une mémoire MRAM. Une telle configuration est décrite en référence à la figure 4, illustrant une mise en commun pour n lignes de mot d'écriture du dispositif selon l'invention, avec les fonctions d'adressage de ces lignes représentées, n valant par exemple 128 ou 256. Chaque ligne d'écriture WL0, WLn-1 est représentée par sa charge résistive équivalente, respectivement R0, ..., Rn-1.

Ainsi, le transistor MOS N3 de la deuxième branche de l'étage cascode régulé Cout est démultiplié en autant de transistors que de lignes d'écriture. Chaque ligne est donc connectée au drain d'un transistor MOS N3 respectif de l'étage cascode régulé Cout, chaque transistor MOS N3 assurant l'adressage en écriture de la ligne d'écriture à laquelle il est associé parmi les n lignes. Le transistor MOS N1 fixant la valeur du courant d'écriture, de même que le reste de la structure de l'étage cascode régulé Cout, sont quant à eux communs aux n lignes d'écriture. Chaque transistor MOS d'adressage N3 associé respectivement à chacune des n lignes d'écriture est donc connecté par sa source au drain du transistor commun N1 de l'étage Cout.

Pour ce qui concerne plus précisément l'adressage d'une ligne d'écriture parmi la pluralité de lignes d'écriture, la grille de chaque transistor d'adressage N3 associé à une ligne d'écriture donnée est connectée à une porte de transfert, respectivement T0, .., Tn-1, présentant deux états en fonction d'un signal d'adressage qui lui est appliqué pouvant prendre deux valeurs adrb et adr, correspondant respectivement à un premier état où la grille du transistor N3 est tirée à la masse tant que la ligne associée n'est pas adressée et un second état où la grille de N3 est connectée à un noeud commun à toutes les portes de transfert, à savoir le drain du transistor N2, quand la ligne associée est adressée, permettant ainsi le passage du courant d'écriture fixé par le transistor commun N1 à travers le transistor N3 sur la ligne d'écriture associé.

Tant qu'une ligne d'écriture n'est pas adressée, la grille du transistor N3 associé est donc maintenue à zéro. Pour ce faire, pour chaque ligne d'écriture, un transistor NMOS N4 est prévu, dont le drain est connecté à la grille du transistor N3 associé et dont la source est connectée à la masse. Lorsque une ligne considérée n'est pas adressée, le transistor N4 est rendu actif en recevant sur sa grille le signal adrb, tirant ainsi la grille du transistor N3 à la masse.

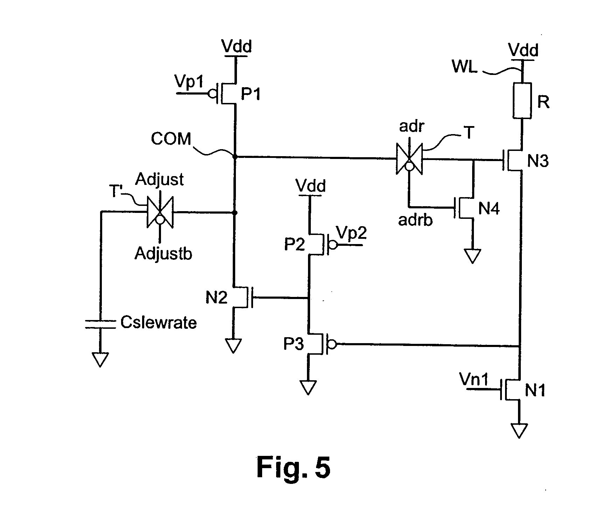

La figure 5 illustre une représentation simplifiée de la figure 4 avec une seule ligne d'écriture, où sont décrits en plus des moyens de contrôle de la pente d'établissement du courant d'écriture, dit encore front de montée du courant d'écriture, qui définit la vitesse d'établissement du courant d'écriture à la valeur souhaitée. Ainsi, lorsqu'une ligne WL est adressée en écriture, la porte de transfert associée T est adressée par un signal d'adressage adr qui est activé. En conséquence, la grille du transistor N3, qui était préalablement tirée à la masse par L'intermédiaire du transistor N4, est activée subitement. A ce stade, N3 étant bloqué, la tension de drain de N1 est nulle, la tension de grille de N2 est alors égale à l'incrément de tension imposé par l'étage suiveur de tension et la tension sur le drain de N2 est proche de Vdd. L'activation de la porte de transfert T provoque alors un transfert de charges, dû au fait que la capacité équivalente sur le noeud commun à toutes les portes de transfert, référencé COM à la figure 5, va venir se décharger au niveau de la capacité équivalente de la grille de N3. Ce phénomène va donc commander la tension sur la grille de N3. En effet, plus la capacité présente au niveau du noeud commun COM est importante, plus la quantité de charges stockées au moment où aucune ligne n'est adressée sera grande et plus l'afflux de charges sur la grille de N3 sera important au moment de la sélection d'une ligne en écriture. La tension sur la grille de N3 montera donc d'autant plus rapidement.

La capacité équivalente présente au niveau du noeud commun COM constitue donc un moyen de gérer la pente d'établissement du courant d'écriture. Selon un mode de réalisation particulier de l'invention, pour faire évoluer cette capacité équivalente lorsque aucune ligne n'est adressée en écriture et ainsi améliorer le contrôle de la pente d'établissement du courant d'écriture, il est prévu de connecter au niveau du noeud commun au moins un condensateur Cslewrate par l'intermédiaire d'une porte de transfert T', présentant deux états en fonction d'un signal logique de sélection pouvant prendre deux valeurs adjust et adjustb. Lorsque la porte T', connectée au condensateur Cslewrate, est adressée par le signal adjust rendu actif, la capacité équivalente présente sur le noeud commun augmente. Celle-ci va alors se charger pendant l'intervalle où aucune ligne n'est sélectionnée en écriture et, au moment où la ligne WL est adressée en écriture, la tension de grille de N3 va évoluer plus rapidement, permettant de ce fait au courant d'écriture de s'établir plus rapidement.

Le front de montée du courant d'écriture est donc modifiée par l'ajout de la capacité Cslewrate. Plus la capacité est grande, plus le front de montée sera rapide. Il est possible de prévoir plusieurs capacités de ce type, associées chacune à une porte de transfert T', afin de contrôler le front de montée du courant d'écriture à l'aide des signaux d'activation des portes de transfert T'. Le front de descente du courant d'écriture est quant à lui contrôlé par le transistor N4. En modifiant son dimensionnement W/L, on peut avoir un front lent (W/L petit), ou un front rapide (W/L important).

Une mémoire MRAM organisée matriciellement en n lignes de bit d'écriture et en m lignes de mot d'écriture comprend un dispositif pour l'établissement d'un courant d'écriture tel qu'il vient d'être décrit pour l'ensemble des n lignes de bit d'écriture et pour l'ensemble des m lignes de mot d'écriture respectivement.

On notera que l'invention ne se limite pas à l'exemple de réalisation décrit en référence aux figures 2 à 5 et, en particulier, d'autres variantes de réalisation, telles que le schéma auto-dual, sont possibles, qui peuvent dépendre de la technologie de fabrication considérée. Ainsi, dans une variante qui reste du domaine de l'invention, on peut considérer que les lignes métalliques d'écriture soient connectées à la masse et que les transistors MOS, référencés N1 et N3 sur les figures, prévus pour fixer le courant d'écriture au niveau de chaque ligne d'écriture, soient choisis de type P. Dans cette variante, exception faite des portes de transfert, les transistors MOS de type N sont remplacés par des transistors MOS de type P et vice versa au niveau des figures précédemment décrites. Les connexions correspondantes de masse et d'alimentation au niveau des transistors sont alors également inversées.

## Revendications

1. Dispositif pour l'établissement d'un courant d'écriture (Iwrite) au niveau d'au moins une ligne conductrice d'écriture (WL0) d'une mémoire en circuit intégré de type MRAM, **caractérisé en ce qu'**il comprend un miroir de courant constitué d'un premier étage cascode régulé de référence (Cin) recevant sur son entrée tout ou partie courant d'écriture et d'un second étage cascode régulé de recopie (Cout) recopiant le courant d'écriture sur la ligne d'écriture.

2. Dispositif selon la revendication 1, **caractérisé en ce qu'**il est utilisé pour établir un courant d'écriture au niveau d'une pluralité de lignes d'écriture, chaque ligne étant connectée au drain d'un transistor MOS (N3) respectif de l'étage cascode régulé de recopie (Cout), ledit transistor MOS (N3) assurant l'adressage de la ligne d'écriture à laquelle il est associé parmi ladite pluralité de lignes.

3. Dispositif selon la revendication 2, **caractérisé en ce que** chaque transistor MOS d'adressage (N3) est connecté par sa source au drain d'un transistor MOS commun (N1) de l'étage cascode régulé de recopie (Cout), prévu pour fixer la valeur du courant d'écriture et dont la grille est connectée en sortie de l'étage cascode régulé de référence (Cin).

4. Dispositif selon la revendication 3, **caractérisé en ce que** l'étage cascode régulé de recopie (Cout) comprend une branche d'asservissement composée d'un transistor MOS (N2) dont la tension de grille est fonction d'un courant (Iregul) fourni par une source de courant (P1) à laquelle il est connecté par son drain, le drain du transistor MOS commun (N1) fixant le courant d'écriture étant connecté à la grille dudit transistor MOS (N2) de la branche d'asservissement par l'intermédiaire d'un étage suiveur de tension (SUIV) fournissant un incrément de tension (ΔV) déterminé à la tension de grille fixée dudit transistor MOS (N2) de ladite branche d'asservissement.

5. Dispositif selon la revendication 4, **caractérisé en ce que**, pour chaque ligne d'écriture considérée, la grille du transistor MOS (N3) d'adressage associé est connectée à une porte de transfert (T0, ..., Tn-1) présentant deux états en fonction d'un signal d'adressage (adr, adrb) qui lui est appliqué, un premier état où ladite grille est tirée à la masse et un second état où ladite grille est connectée au drain du transistor MOS (N2) de la branche d'asservissement de l'étage cascode régulé de recopie (Cout), permettant le passage du courant d'écriture fixé par le transistor commun (N1) à travers ledit transistor MOS (N3) d'adressage sur ladite ligne.

6. Dispositif selon l'une quelconque des revendications précédentes, **caractérisé en ce que** l'étage cascode régulé de recopie (Cout) comprend des moyens de contrôle de la pente d'établissement du courant d'écriture.

7. Dispositif selon les revendications 5 et 6, **caractérisé en ce que** les moyens de contrôle de la pente d'établissement du courant d'écriture comprennent au moins un condensateur (Cslewrate), connecté au drain du transistor MOS (N2) de la branche d'asservissement de l'étage cascode régulé de recopie (Cout), par l'intermédiaire d'une porte de transfert (T') respective, ladite porte (T') étant prévue pour être activée lorsque aucune ligne n'est adressée en écriture, de sorte à faire évoluer la capacité équivalente au niveau du drain du transistor MOS (N2) de ladite branche d'asservissement.

8. Dispositif selon l'une quelconque des revendications 4 à 7, **caractérisé en ce que** la source de courant de la branche d'asservissement de l'étage cascode régulé de recopie comprend un transistor PMOS (P1) dont la grille est connectée à une tension de polarisation (Vp1), la source est connectée à une tension d'alimentation (VDD) et le drain est connecté au drain de l'autre transistor MOS (N2) de la branche d'asservissement.

9. Dispositif selon la revendication 8, **caractérisé en ce que** les transistors (P1, N2) de la branche d'asservissement fonctionnent en régime de saturation.

10. Dispositif selon l'une quelconque des revendications 4 à 9, **caractérisé en ce que** l'étage suiveur de tension comprend un premier transistor PMOS (P2), dont la source est connectée à une tension d'alimentation (VDD), la grille est connectée à une tension de polarisation (Vp2) et le drain est connecté à la source d'un second transistor PMOS (P3) dont le drain est connecté à la masse, ladite source dudit second transistor PMOS étant connectée à la grille du transistor MOS (N2) de la branche d'asservissement et la grille dudit second transistor PMOS (P3) dudit étage suiveur de tension étant connectée au drain du transistor MOS (N1) commun prévu pour fixer la valeur du courant d'écriture, ledit second transistor PMOS (P3) dudit étage suiveur de tension étant prévu pour appliquer une tension reçue sur sa grille au niveau de sa source en y ajoutant l'incrément de tension (ΔV).

11. Mémoire de type MRAM, **caractérisée en ce qu'**elle comprend au moins un dispositif d'établissement d'un courant d'écriture selon l'une quelconque des revendications précédentes.

12. Mémoire selon la revendication 11, organisée matriciellement en lignes de bit d'écriture et en lignes de mot d'écriture, **caractérisé en ce qu'**elle comprend un dispositif d'établissement d'un courant d'écriture pour l'ensemble des lignes de bit d'écriture et pour l'ensemble des lignes de mot d'écriture respectivement.

13. Circuit intégré comprenant un dispositif d'établissement d'un courant d'écriture ou une mémoire selon l'une quelconque des revendications précédentes.
